# EUROPEAN PATENT APPLICATION

(11) **EP 3 608 947 A1**
(43) Date of publication of application: **12.02.2020**
(21) Application number: 18774927.0
(22) Date of filing: 30.01.2018
(51) Int. Cl.: H01L 21/52, C09J 1/00, C09J 7/00, C09J 7/20, C09J 133/04, C09J 169/00, H01L 21/301

(54) **THERMAL-BONDING SHEET AND THERMAL-BONDING SHEET-ATTACHED DICING TAPE**

(30) Priority: 29.03.2017 JP 2017064501
(71) Applicant: Nitto Denko Corporation, Ibaraki-shi, Osaka 567-8680 (JP)
(72) Inventor: SUGO, Yuki, Ibaraki-shi Osaka 567-8680 (JP); HONDA, Satoshi, Ibaraki-shi Osaka 567-8680 (JP); SHIMODA, Mayu, Ibaraki-shi Osaka 567-8680 (JP)
(74) Representative: Grünecker Patent- und Rechtsanwälte PartG mbB
(86) International application number: PCT/JP2018/003005
(87) International publication number: WO 2018/179796

(57) **Abstract**

[Object] Provided are: a thermal bonding sheet suitable for actually providing sinter bonding between bonding targets while reducing misalignment of the bonding targets, and a dicing tape with such a thermal bonding sheet. [Solution] This thermal bonding sheet (10) includes a pressure-sensitive adhesive layer (11) including sinterable particles containing a conductive metal. The pressure-sensitive adhesive layer (11) has a shear bond strength of 0.1 MPa or more determined at 70°C with respect to a silver plane to which the pressure-sensitive adhesive layer (11) as a 5-mm square piece has been compression-bonded under compression bonding conditions of 70°C, 0.5 MPa, and 1 second. The thermal bonding sheet-associated dicing tape includes a dicing tape and the thermal bonding sheet (10). The dicing tape has a multilayer structure including a base and a pressure-sensitive adhesive layer. The thermal bonding sheet (10) is disposed on the pressure-sensitive adhesive layer of the dicing tape.

## Description

### Technical Field

The present invention relates to thermal bonding sheets usable for the production of semiconductor devices, and to dicing tapes each with such a thermal bonding sheet.

### Background Art

In some semiconductor device productions, a semiconductor chip is die-bonded to a supporting substrate such as a lead frame or an insulated substrate while establishing and keeping electrical connection with the supporting substrate. Known examples of this technique include the technique of forming a Au-Si eutectic alloy layer between the supporting substrate and the chip to achieve a bonding state; and the technique of using a bonding material such as solder or a resin containing conductive particles.

Power semiconductor devices, which assume power supply and control, have become widespread remarkably. Many of such power semiconductor devices output large heat due to the passage of large current during operation. The power semiconductor device productions require a technique of die-bonding a semiconductor chip on a supporting substrate while establishing and keeping electrical connection with the supporting substrate, where the technique actually provides a highly reliable bonding state even during a high-temperature operation. In particular, power semiconductor devices that employ SiC or GaN as a semiconductor material and are to be operated at high temperatures significantly demand this. A proposed die bonding technique with electrical connection to meet the requirement employs a material for thermal bonding (thermal-bonding material) including a composition containing, for example, sinterable particles and a solvent.

The die bonding technique using such a thermal-bonding material containing sinterable particles initially mounts a semiconductor chip through the thermal-bonding material onto a predetermined chip-mounting area of the supporting substrate under predetermined temperature-load conditions. The technique then performs a heating step under predetermined temperature-pressurization conditions to cause, for example, volatilization of the solvent from the thermal-bonding material disposed between the supporting substrate and the overlying semiconductor chip and to allow sintering to proceed between the sinterable particles. This allows the semiconductor chip to be electrically connected to, and mechanically bonded to, the supporting substrate. The technique as above can be found typically in Patent Literature (PTL) 1, PTL 2, and PTL 3 as follows.

### Citation List

### Patent Literature

PTL 1: PCT International Publication Number WO2008/065728
PTL 2: Japanese Unexamined Patent Application Publication (JP-A) No. 2013-039580
PTL 3: JP-A No. 2014-111800

### Summary of Invention

### Technical Problem

The conventional die bonding using a thermal-bonding material containing sinterable particles may suffer from chip shift, namely, misalignment of the semiconductor chip due to deformation or flow of the thermal-bonding material used, during or after mounting of the semiconductor chip on the supporting substrate through the thermal-bonding material. The occurrence of such misalignment can cause lower yield of the semiconductor device to be produced.

The present invention has been made under these circumstances and has an object to provide a thermal bonding sheet suitable for actually providing sinter bonding while reducing misalignment of bonding targets, and to provide a dicing tape associated with such a thermal bonding sheet. Solution to Problem

A first aspect of the present invention provides a thermal bonding sheet. This thermal bonding sheet includes a pressure-sensitive adhesive layer including sinterable particles containing a conductive metal. In the thermal bonding sheet, the pressure-sensitive adhesive layer has a first shear bond strength of 0.1 MPa or more, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second. As used herein, the term "shear bond strength" refers to a value measured at a displacement velocity of a bond strength measurement target in the shear direction of 0.5 mm/second. The thermal bonding sheet, which has the configuration as above, is usable for sinter bonding between bonding targets. For example, the thermal bonding sheet is usable in semiconductor device production for sinter bonding of a semiconductor chip to a supporting substrate, while establishing and keeping electrical connection with the supporting substrate.

In the process for actually providing sinter bonding using a thermal-bonding material for sinter bonding, the bonding targets are compression-bonded to each other under predetermined temperature-load conditions with the material being present between the bonding targets and, in addition, are heated at a high sinter-bonding temperature to form a sintered layer, which bonds between the bonding targets. The compression bonding is performed at a temperature of typically from 50°C to 90°C, where the temperature range is a temperature range including 70°C and the vicinities thereof. The compression bonding under this temperature condition is expected to offer better compression bonding properties without abrupt compositional change, as compared with compression bonding at normal temperature. The thermal bonding sheet according to the first aspect of the present invention has a shear bond strength at 70°C as defined above of 0.1 MPa or more. The configuration as above is advantageous for reducing misalignment of bonding targets, during or after compression bonding between the bonding targets with the thermal bonding sheet being present between the bonding targets. Assume that the thermal bonding sheet is used for sinter bonding of a semiconductor chip onto a supporting substrate. In this case, for example, the configuration for the thermal bonding sheet of having a shear bond strength at 70°C as defined above of 0.1 MPa or more is advantageous for reducing chip shift, namely, misalignment of the semiconductor chip during temporary securing in which the semiconductor chip is compression-bonded to the supporting substrate with the sheet being present between the supporting substrate and the semiconductor chip. The reduction in such misalignment during temporary securing is advantageous for preventing or minimizing sinter bonding of the semiconductor chip to the supporting substrate with misalignment beyond the bounds of permissibility and is advantageous for better yield of the semiconductor device to be produced.

The thermal bonding sheet is also suitable for bonding between bonding targets through a sintered layer having an even thickness. Such a thermal-bonding material for sinter bonding, when fed and applied in the form of a paste onto bonding targets, may give a layer having an uneven thickness. The layer of the thermal-bonding material paste, if having such an uneven thickness, gives an ununiform sintered layer, which bonds between the bonding targets therethrough. In contrast, the thermal bonding sheet can be fed as a bonding material, which is prepared in the form of a sheet having an even thickness, onto bonding targets and enables bonding between the bonding targets through a sintered layer having an even thickness. The sinter bonding through such a sintered layer having an even thickness is advantageous for actually providing high bonding reliability typically of a semiconductor chip to a supporting substrate.

In addition, the thermal bonding sheet is suitable for sinter bonding between bonding targets while allowing the sintered metal to resist oozing from between the bonding targets and to resist creeping up to the bonding targets. A thermal-bonding material for sinter bonding, when fed in the form of a paste to between bonding targets, is liable to fluidize during temperature rise process. This may cause the sintered metal to ooze from between the bonding targets or to creep up at the sides of the bonding targets. In contrast, the thermal bonding sheet is fed as a thermal-bonding material for sinter bonding in the form of a sheet, which resists fluidization, and resists such oozing and creeping up. The reduction in oozing and creeping up as above is advantageous for better yield in a semiconductor device or another target of production with sinter bonding.

Assuming that the pressure-sensitive adhesive layer has a second shear bond strength, the pressure-sensitive adhesive layer preferably has a ratio of the second shear bond strength to the first shear bond strength of 5 to 40, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second, and where the second shear bond strength is a shear bond strength determined at 23°C with respect to a silver plane to which the pressure-sensitive adhesive layer as a 5-mm square piece has been compression-bonded under compression bonding conditions of 70°C, 0.5 MPa, and 1 second. The configuration of the thermal bonding sheet ensures the relative strength of the first shear bond strength to the second shear bond strength within such a range that the ratio of the second shear bond strength to the first shear bond strength is from 5 to 40, where the first shear bond strength is determined at 70°C, which is a temperature within the temporary securing temperature range, and the second shear bond strength is determined at 23°C, which is a temperature within the normal temperature range. This configuration is preferred for reducing or restraining the chip shift or misalignment.

The pressure-sensitive adhesive layer in the thermal bonding sheet has a third shear bond strength of preferably 0.11 MPa or more, where the third shear bond strength is a shear bond strength determined at 50°C with respect to a silver plane to which the pressure-sensitive adhesive layer as a 5-mm square piece has been compression-bonded under compression bonding conditions of 50°C, 0.5 MPa, and 1 second. Temporary securing in the presence of a thermal-bonding material for sinter bonding disposed between bonding targets is performed typically at a temperature of from 50°C to 90°C, which temperature range is a temperature range including 70°C and the vicinities thereof, as described above. The thermal bonding sheet, when having the above configuration in which the third shear bond strength is 0.11 MPa or more is preferred for reducing the chip shift or misalignment.

The pressure-sensitive adhesive layer in the thermal bonding sheet preferably has a ratio of the third shear bond strength to the first shear bond strength of 1 to 40, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second, and where the third shear bond strength is a shear bond strength determined at 50°C with respect to a silver plane to which the pressure-sensitive adhesive layer as a 5-mm square piece has been compression-bonded under compression bonding conditions of 50°C, 0.5 MPa, and 1 second. This configuration is preferred for allowing the thermal bonding sheet to actually offer a stable bond strength within the temporary securing temperature range and is preferred for reducing the chip shift or misalignment.

Assuming that the pressure-sensitive adhesive layer in the thermal bonding sheet has a fourth shear bond strength, the pressure-sensitive adhesive layer preferably has a ratio of the fourth shear bond strength to the first shear bond strength of 1 to 40, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second, and where the fourth shear bond strength is a shear bond strength determined at 90°C with respect to a silver plane to which the pressure-sensitive adhesive layer as a 5-mm square piece has been compression-bonded under compression bonding conditions of 90°C, 0.5 MPa, and 1 second. This configuration is preferred for allowing the thermal bonding sheet to actually have stable adhesive strength within the temporary securing temperature range and is suitable for reducing the chip shift or misalignment.

The pressure-sensitive adhesive layer in the thermal bonding sheet preferably has a viscosity of 5 ×10³ to 1 ×10⁷ Pa·s at 70°C. The configuration as above is advantageous for the thermal bonding sheet to actually have a first shear bond strength at the specific level or greater.

The pressure-sensitive adhesive layer in the thermal bonding sheet preferably further includes a thermally decomposable polymer binder in addition to the sinterable particles containing a conductive metal. As used herein, the term "thermally decomposable polymer binder" refers to a polymer binder component that can be thermally decomposable in a high-temperature heating process for sinter bonding. The configuration as above allows the pressure-sensitive adhesive layer to readily surely have cohesive force by utilizing, for example, the viscoelasticity of the thermally decomposable polymer binder, at a temperature from 50°C to 90°C, where the temperature range is a temperature range including the temporary securing temperatures, namely, 70°C and the vicinities thereof. This in turn allows the pressure-sensitive adhesive layer to readily have a certain bond strength surely. Thus, the configuration is advantageously for allowing the thermal bonding sheet to actually have a first shear bond strength at the specific level or greater.

In the thermal bonding sheet, the thermally decomposable polymer binder preferably has a weight-average molecular weight of 10000 or more. The configuration as above is advantageous for allowing the pressure-sensitive adhesive layer to surely have a cohesive force and a bond strength at certain levels by utilizing the viscoelasticity of the thermally decomposable polymer binder.

The thermally decomposable polymer binder in the thermal bonding sheet is preferably at least one of a polycarbonate resin and an acrylic resin. As described above, the process of actually providing sinter bonding using a thermal-bonding material for sinter bonding temporarily secures between bonding targets by the working of the material, and then performs high-temperature heating for sinter bonding. The high-temperature heating for sinter bonding is performed typically in a temperature range including 300°C and the vicinities thereof. Such polycarbonate resins and acrylic resins are readily preparable as polymer binders that decompose and/or vaporize at a temperature around 300°C. The configuration is advantageous for reducing an organic residue in a sintered layer formed between bonding targets to be bonded through sintering using the thermal bonding sheet. With a decreasing organic residue in the sintered layer, the sintered layer tends to be firmer or more rigid and tends to offer better bonding reliability.

The sinterable particles in the thermal bonding sheet preferably include at least one selected from the group consisting of silver, copper, silver oxide, and copper oxide. The configuration as above is advantageous for forming a strong sintered layer between bonding targets to be bonded by sintering using the thermal bonding sheet.

A second aspect of the present invention provides a dicing tape with a thermal bonding sheet (thermal bonding sheet-associated dicing tape). The thermal bonding sheet-associated dicing tape includes a dicing tape and the thermal bonding sheet according to the first aspect of the present invention. The dicing tape has a multilayer structure including a base (carrier or substrate) and a pressure-sensitive adhesive layer. The thermal bonding sheet is disposed on the pressure-sensitive adhesive layer of the dicing tape. The dicing tape having the configuration as above is usable in a semiconductor device production process to give semiconductor chips each with a chip-size thermal bonding sheet. The dicing tape gives advantageous effects in sinter bonding in a semiconductor device production process, as described above relating to the thermal bonding sheet according to the first aspect of the present invention.

### Brief Description of Drawings

FIG. 1 is a schematic partial cross-sectional view of a thermal bonding sheet according to an embodiment of the present invention;
FIG. 2 illustrates a part of steps in a semiconductor device production method using the thermal bonding sheet illustrated in FIG. 1;
FIG. 3 illustrates a part of steps in the semiconductor device production method using the thermal bonding sheet illustrated in FIG. 1;
FIG. 4 illustrates a part of steps in the semiconductor device production method using the thermal bonding sheet illustrated in FIG. 1;
FIG. 5 is a schematic partial cross-sectional view of a thermal bonding sheet-associated dicing tape according to an embodiment of the present invention; and
FIG. 6 illustrates a part of steps in a semiconductor device production method using the thermal bonding sheet-associated dicing tape illustrated in FIG. 5.

### Description of Embodiments

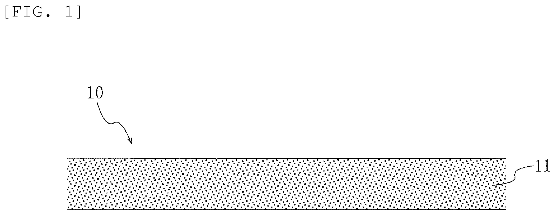

FIG. 1 is a schematic partial cross-sectional view of a thermal bonding sheet 10 according to an embodiment of the present invention. The thermal bonding sheet 10 is used for sinter bonding between bonding targets and includes a pressure-sensitive adhesive layer 11. The pressure-sensitive adhesive layer 11 includes sinterable particles containing a conductive metal (conductive-metal-containing sinterable particles), a thermally decomposable polymer binder, and a low-boiling binder. The thermal bonding sheet 10 as above is usable, typically in a semiconductor device production process, for sinter bonding of a semiconductor chip to a supporting substrate while establishing and keeping electrical connection with the supporting substrate.

The sinterable particles contained in the thermal bonding sheet 10 or in the pressure-sensitive adhesive layer 11 of the sheet 10 are particles that contain a conductive metal element and are sinterable. Non-limiting examples of the conductive metal element include gold, silver, copper, palladium, tin, and nickel. Examples of the material to constitute such sinterable particles include gold, silver, copper, palladium, tin, and nickel; and alloys of two or more metals selected from the group consisting of these metals. Examples of the material to constitute the sinterable particles also include metal oxides such as silver oxide, copper oxide, palladium oxide, and tin oxide. The sinterable particles may be particles having a core-shell structure. For example, the sinterable particles may be core-shell structure particles, which include a core mainly containing copper, and a shell mainly containing, for example, gold or silver and covering the core. In the embodiment, the sinterable particles preferably include at least one selected from the group consisting of silver particles, copper particles, silver oxide particles, and copper oxide particles.

The sinterable particles have an average particle size of preferably 1000 nm or less, more preferably 800 nm or less, and still more preferably 500 nm or less, from the viewpoint of surely providing satisfactory sinterability typically by allowing the sinterable particles to actually have a low sintering temperature. The sinterable particles have an average particle size of preferably 10 nm or more, more preferably 50 nm or more, and still more preferably 100 nm or more, from the viewpoint of allowing the sinterable particles to be surely satisfactorily dispersible in the pressure-sensitive adhesive layer 11 or in a composition to form the layer 11.

The average particle size of the sinterable particles can be measured by observation using a scanning electron microscope (SEM). Specifically, the average particle size of the sinterable particles contained in the pressure-sensitive adhesive layer can be measured in the following manner. Initially, the pressure-sensitive adhesive layer containing the sinterable particles undergoes ion polishing in a cooling environment to expose a cross section of the pressure-sensitive adhesive layer. Next, an image of the exposed cross section is taken using a field emission scanning electron microscope SU8020 (Hitachi High-Technologies Corporation) to give a backscattered electron image as image data. The imaging is performed at an acceleration voltage of 5 kV and a 50000-fold magnification. Next, the obtained image data undergoes automatic binarization and then calculation of the average particle size of particles, using an image analyzing software, ImageJ.

Copper particles, when used as the sinterable particles, each preferably include two or more different crystallites. The crystallites constituting the copper particles have a diameter of preferably 50 nm or less, and more preferably 45 nm or less, from the viewpoint of surely providing satisfactory sinterability typically by allowing the sinterable particles to actually have a low sintering temperature. The crystallite diameter in the copper particles herein refers to a value determined by subjecting the copper particles to X-ray diffractometry using an X-ray diffractometer Ultima IV (Rigaku Corporation) and calculating the crystallite diameter by the Scherrer method using the obtained (111) peak value.

The sinterable particles are present in the pressure-sensitive adhesive layer 11 in a proportion of preferably 60 to 98 mass percent, more preferably 65 to 97 mass percent, and still more preferably 70 to 95 mass percent, from the viewpoint of actually providing highly reliable sinter bonding.

The thermally decomposable polymer binder contained in the thermal bonding sheet 10 or in the pressure-sensitive adhesive layer 11 of the sheet 10 is a polymer binder component that is thermally decomposable in a high-temperature heating process for sinter bonding, and is an element that contributes to a maintained sheet form of the thermal bonding sheet 10 or the pressure-sensitive adhesive layer 11 of the sheet 10 before the heating process. In the embodiment, the thermally decomposable polymer binder is preferably a material that is solid at normal temperature (23°C), from the viewpoint of surely functioning to maintain the sheet form. Non-limiting examples of such thermally decomposable polymer binders include polycarbonate resins and acrylic resins.

Examples of such a polycarbonate resin, when used as the thermally decomposable polymer binder, include aliphatic polycarbonates which are devoid of benzene rings and other moieties derived from aromatic compounds between carbonic acid ester groups (-O-CO-O-) in the backbone and are composed of an aliphatic chain; and aromatic polycarbonates which include a moiety derived from an aromatic compound between carbonic acid ester groups (-O-CO-O-) in the backbone. Non-limiting examples of the aliphatic polycarbonates include poly(ethylene carbonate)s and poly(propylene carbonate)s. Non-limiting examples of the aromatic polycarbonates include polycarbonates including a bisphenol-A structure in the backbone.

Examples of such an acrylic resin, when used as the thermally decomposable polymer binder, include polymers of an acrylic ester and/or a methacrylic ester each having C₄-C₁₈ linear or branched alkyl. Hereinafter the term "(meth)acrylic" indicates "acrylic" and/or "methacrylic". Non-limiting examples of the alkyl moiety of the (meth)acrylic ester to form the acrylic resin as the thermally decomposable polymer binder include methyl, ethyl, propyl, isopropyl, n-butyl, t-butyl, isobutyl, amyl, isoamyl, hexyl, heptyl, cyclohexyl, 2-ethylhexyl, octyl, isooctyl, nonyl, isononyl, decyl, isodecyl, undecyl, lauryl, tridecyl, tetradecyl, stearyl, and octadecyl.

The acrylic resin as the thermally decomposable polymer binder may also be a polymer further including a monomer unit derived from a monomer other than the (meth)acrylic esters. Examples such other monomers include carboxy-containing monomers, acid anhydride monomers, hydroxy-containing monomers, sulfonate-containing monomers, and phosphate-containing monomers. Specifically, non-limiting examples of the carboxy-containing monomers include acrylic acid, methacrylic acid, carboxyethyl acrylate, carboxypentyl acrylate, itaconic acid, maleic acid, fumaric acid, and crotonic acid. Examples of the acid anhydride monomers include, but are not limited to, maleic anhydride and itaconic anhydride. Non-limiting examples of the hydroxy-containing monomers include 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and 4-(hydroxymethyl)cyclohexylmethyl (meth)acrylate. Non-limiting examples of the sulfonate-containing monomers include styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. Non-limiting examples of the phosphate-containing monomers include 2-hydroxyethylacryloyl phosphate.

The thermally decomposable polymer binder has a weight-average molecular weight of preferably 10000 or more. The weight-average molecular weight of the thermally decomposable polymer binder herein refers to a value measured by gel permeation chromatography (GPC) and calibrated with a polystyrene standard.

The thermally decomposable polymer binder may be present in the pressure-sensitive adhesive layer 11 in a proportion of preferably 0.5 to 40 mass percent, more preferably 0.8 to 30 mass percent, and still more preferably 1 to 20 mass percent, from the viewpoint of appropriately functioning to maintain the sheet form.

The low-boiling binder contained in the thermal bonding sheet 10 or in the pressure-sensitive adhesive layer 11 of the sheet 10 refers to a binder that has a viscosity of 1 ×10⁵ Pa·s or less and is liquid or semi-liquid at 23°C, where the viscosity is measured using a dynamic viscoelastometer HAAKE MARS III (trade name, ThermoFISHER SCIENTFIC). The viscosity measurement is performed using 20-mm diameter parallel plates as fixtures at a gap between the plates of 100 µm and a shear rate in rotary shearing of 1 s⁻¹.

Non-limiting examples of the low-boiling binder contained in the pressure-sensitive adhesive layer 11 include terpene alcohols, alcohols other than terpene alcohols, alkylene glycol alkyl ethers, and ethers other than alkylene glycol alkyl ethers. Examples of the terpene alcohols include isobornylcyclohexanol, citronellol, geraniol, nerol, carveol, and α-terpineol. Non-limiting examples of the alcohols other than terpene alcohols include pentanol, hexanol, heptanol, octanol, 1-decanol, ethylene glycol, diethylene glycol, propylene glycol, butylene glycol, and 2,4-diethyl-1,5-pentanediol. Non-limiting examples of the alkylene glycol alkyl ethers include ethylene glycol butyl ether, diethylene glycol methyl ether, diethylene glycol ethyl ether, diethylene glycol butyl ether, diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, and tripropylene glycol dimethyl ether. Non-limiting examples of the ethers other than alkylene glycol alkyl ethers include ethylene glycol ethyl ether acetate, ethylene glycol butyl ether acetate, diethylene glycol ethyl ether acetate, diethylene glycol butyl ether acetate, dipropylene glycol methyl ether acetate, and ethylene glycol phenyl ether. The pressure-sensitive adhesive layer 11 may contain each of different low-boiling binders alone or in combination. The low-boiling binder to be contained in the pressure-sensitive adhesive layer 11 is preferably selected from terpene alcohols and is more preferably isobornylcyclohexanol, from the viewpoint of stability at normal temperature (room temperature).

The thermal bonding sheet 10 or the pressure-sensitive adhesive layer 11 of the sheet 10 may further contain any other component such as a plasticizer, in addition to the above-mentioned components.

The pressure-sensitive adhesive layer 11 has a thickness at 23°C of preferably 5 µm or more, and more preferably 10 µm or more; and preferably 100 µm or less, and more preferably 80 µm or less. The pressure-sensitive adhesive layer 11 has a viscosity at 70°C (namely, the composition constituting the pressure-sensitive adhesive layer 11 has a viscosity at 70°C) of preferably 5 ×10³ to 1 ×10⁷ Pa·s, and more preferably 1 ×10⁴ to 1 ×10⁶ Pa·s.

The thermal bonding sheet 10 or the pressure-sensitive adhesive layer 11 of the sheet 10 includes the conductive-metal-containing sinterable particles, the thermally decomposable polymer binder, and the low-boiling binder, as described above. In the thermal bonding sheet 10, which has the configuration as above relating to the pressure-sensitive adhesive layer formula, the pressure-sensitive adhesive layer 11 has a first shear bond strength of 0.1 MPa or more, preferably 0.12 MPa or more, more preferably 0.14 MPa or more, still more preferably 0.16 MPa or more, still more preferably 0.18 MPa or more, and still more preferably 0.2 MPa or more, where the first shear bond strength is a shear bond strength determined at 70°C with respect to a silver plane to which the pressure-sensitive adhesive layer 11 as a 5-mm square piece has been compression-bonded under compression bonding conditions of 70°C, 0.5 MPa, and 1 second (first compression bonding conditions). In the embodiment, the "shear bond strength" refers to a value measured under such conditions as to give a displacement velocity of the bond strength measurement target in the shear direction of 0.5 mm/second.

Assuming that the pressure-sensitive adhesive layer 11 in the thermal bonding sheet 10 has a second shear bond strength, the pressure-sensitive adhesive layer 11 has a ratio of the second shear bond strength to the first shear bond strength of preferably 5 to 40, and more preferably 6 to 30, where the first shear bond strength is a shear bond strength determined at 70°C with respect to a silver plane to which the pressure-sensitive adhesive layer 11 as a 5-mm square piece has been compression-bonded under the first compression bonding conditions, and where the second shear bond strength is a shear bond strength determined at 23°C with respect to a silver plane to which the pressure-sensitive adhesive layer 11 as a 5-mm square piece has been compression-bonded under the same first compression bonding conditions.

The pressure-sensitive adhesive layer 11 in the thermal bonding sheet 10 has a third shear bond strength of preferably 0.11 MPa or more, and more preferably 0.15 MPa or more, where the third shear bond strength is a shear bond strength determined at 50°C with respect to a silver plane to which the pressure-sensitive adhesive layer 11 as a 5-mm square piece has been compression-bonded under compression bonding conditions of 50°C, 0.5 MPa, and 1 second (second compression bonding conditions). The pressure-sensitive adhesive layer 11 in the thermal bonding sheet 10 has a ratio of the third shear bond strength to the first shear bond strength of preferably 1 to 40, and more preferably 6 to 30, where the first shear bond strength is a shear bond strength determined at 70°C with respect to a silver plane to which the pressure-sensitive adhesive layer 11 as a 5-mm square piece has been compression-bonded under the first compression bonding conditions, and where the third shear bond strength is a shear bond strength determined at 50°C with respect to a silver plane to which the pressure-sensitive adhesive layer 11 as a 5-mm square piece has been compression-bonded under the second compression bonding conditions.

Assuming that the pressure-sensitive adhesive layer 11 in the thermal bonding sheet 10 has a fourth shear bond strength, the pressure-sensitive adhesive layer 11 has a ratio of the fourth shear bond strength to the first shear bond strength of preferably 1 to 40, and more preferably 6 to 30, where the first shear bond strength is a shear bond strength determined at 70°C with respect to a silver plane to which the pressure-sensitive adhesive layer 11 as a 5-mm square piece has been compression-bonded under the first compression bonding conditions, and where the fourth shear bond strength is a shear bond strength determined at 90°C with respect to a silver plane to which the pressure-sensitive adhesive layer 11 as a 5-mm square piece has been compression-bonded under compression bonding conditions of 90°C, 0.5 MPa, and 1 second (third compression bonding conditions).

The bond strength of thermal bonding sheet 10 or the pressure-sensitive adhesive layer 11 of the sheet 10 can be controlled typically by adjusting the constitutional monomer formula and/or the weight-average molecular weight of the thermally decomposable polymer binder; selecting the low-boiling binder; adjusting the contents of components such as the sinterable particles, the thermally decomposable polymer binder, and the low-boiling binder in the pressure-sensitive adhesive layer 11; and/or setting the thickness of the pressure-sensitive adhesive layer 11.

The thermal bonding sheet 10 can be prepared typically by mixing the components in a solvent to give a varnish, applying the varnish onto a separator, which will serve as a base, to form a coating, and drying the coating. The solvent for varnish preparation is selectable typically from organic solvents and alcohol solvents. Non-limiting examples of the organic solvents include dimethylformamide, dimethylacetamide, N-methylpyrrolidone, acetone, methyl ethyl ketone, cyclohexanone, toluene, and xylene. Non-limiting examples of the alcohol solvents include ethylene glycol, diethylene glycol, 1,2-propanediol, 1,3-propanediol, 1,2-butanediol, 1,3-butanediol, 1,4-butanediol, 2-butene-1,4-diol, 1,2,6-hexanetriol, glycerol, octanediol, 2-methyl-2,4-pentanediol, and terpineol. The varnish can be applied onto the base typically using a die coater, gravure coater, roll coater, reverse coater, comma coater, or pipe doctor coater. The coating is dried at a temperature of typically 70°C to 160°C for a time of typically 1 to 5 minutes. The base or separator usable herein may be selected from poly(ethylene terephthalate) (PET) films, polyethylene films, polypropylene films, and various plastic films and paper whose surface is coated with a release agent (such as a fluorine release agent or a long-chain alkyl acrylate release agent).

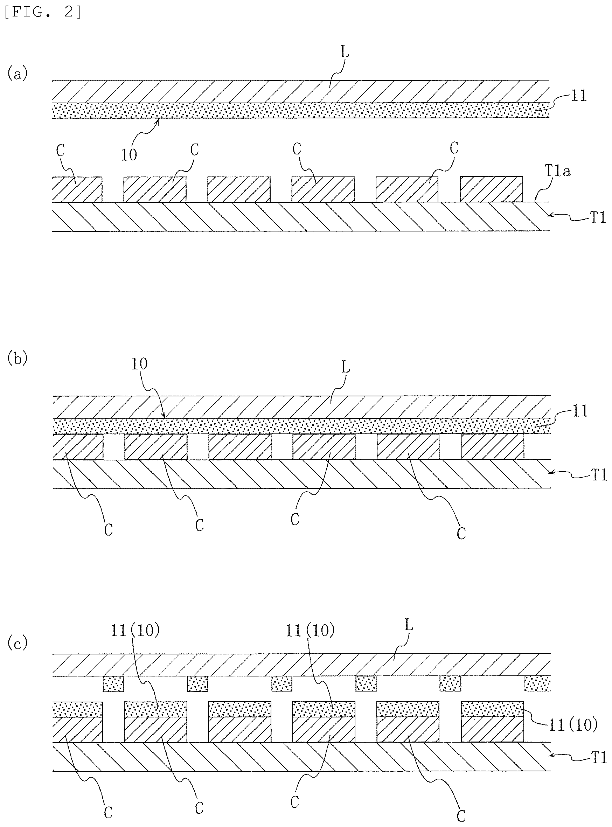

FIGs. 2 to 4 illustrate a part of steps in a semiconductor device production method using the thermal bonding sheet 10.

The method initially prepares a thermal bonding sheet 10 and semiconductor chips C as illustrated in FIG. 2(a). The thermal bonding sheet 10 includes the pressure-sensitive adhesive layer 11 having the configuration and bears a release liner L on one side of the pressure-sensitive adhesive layer 11. Each semiconductor chip C includes a predetermined semiconductor element or elements, which have been made already, and is secured onto an adhesive face T1a of a chip-securing tape T1. Each semiconductor chip C includes a silver plane electrode (not shown) already formed as an external electrode on a surface on which the thermal bonding sheet 10 will be applied (the upper side in FIG. 2). The silver plane electrode has a thickness of typically 10 to 1000 nm. The silver plane electrode may be formed on a thin titanium film which is formed on the surface of the semiconductor chip. The thin titanium film has a thickness of typically 10 to 1000 nm. These silver plane electrode and thin titanium film may be formed typically by a vapor deposition technique. Each semiconductor chip C bears, as needed, other components such as electrode pads (not shown) on the other side (the under side in FIG. 2).

Next, the thermal bonding sheet 10 is applied to the semiconductor chips C, as illustrated in FIG. 2(b). Specifically, the thermal bonding sheet 10, or the pressure-sensitive adhesive layer 11, is applied to the semiconductor chips C while the thermal bonding sheet 10 is pressed from the release liner L side toward the semiconductor chips C. A non-limiting example of the pressing means is a pressure roller. The application is performed at a temperature of typically 50°C to 90°C under a load of typically 0.01 to 5 MPa.

Next, the release liner L is removed from the chip-securing tape T1 side, as illustrated in FIG. 2(c). This transfers portions of the thermal bonding sheet 10 or the pressure-sensitive adhesive layer 11 of the sheet 10 to the surfaces of the individual semiconductor chips C, to give semiconductor chips C each with a chip-size piece of the thermal bonding sheet 10.

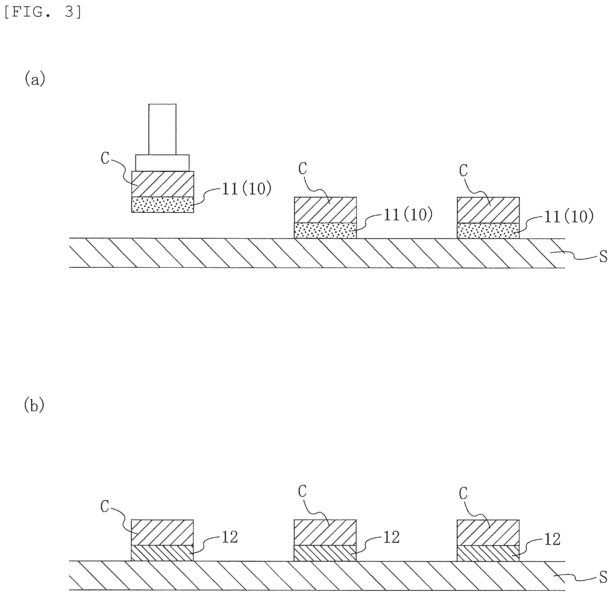

Each semiconductor chip C is then temporarily secured to a supporting substrate S (temporary securing step), as illustrated in FIG. 3(a). Specifically, each thermal bonding sheet-associated semiconductor chip C is temporarily secured through the thermal bonding sheet 10 to the supporting substrate S using, for example, a chip mounter. Non-limiting examples of the supporting substrate S include insulated circuit boards bearing copper wiring on the surface; and lead frames. On the supporting substrate S, the chip may be mounted on the base material such as a copper wiring or lead frame, or may be mounted on a plated film disposed on the base material. Non-limiting examples of the plated film include gold plated films, silver plated films, nickel plated films, palladium plated films, and platinum plated films. For example, when a silver plated film is disposed in the chip-mounting area of the supporting substrate S, the chip-mounting area serves as a silver plane. In the step, the temporary securing is performed at a temperature in the range of typically from 50°C to 90°C, which is a temperature range including 70°C and the vicinities thereof, by pressing under a load of typically 0.01 to 5 MPa for a bonding time of typically 0.01 to 5 seconds.

The work then undergoes a high-temperature heating process to allow the semiconductor chips C to bond to the supporting substrate S (thermal bonding step), as illustrated in FIG. 3(b). Specifically, in the pressure-sensitive adhesive layer 11 disposed between the supporting substrate S and each semiconductor chip C, such a predetermined high-temperature heating process causes the low-boiling binder to volatilize, causes the thermally decomposable polymer binder to thermally decompose and to volatilize, and causes the conductive metal in the sinterable particles to sinter. This forms a sintered layer 12 between the supporting substrate S and each semiconductor chip C and bonds the semiconductor chip C to the supporting substrate S while establishing and keeping electrical connection of the semiconductor chip C with the supporting substrate S. The step performs the thermal bonding at a temperature of typically 200°C to 400°C, which range includes 300°C and the vicinities thereof, and preferably 330°C to 350°C and a pressure of typically 0.05 to 40 MPa, and preferably 0.1 to 20 MPa, for a bonding time of preferably 0.3 to 300 minutes, more preferably 0.5 to 240 minutes, and still more preferably 1 to 180 minutes. The temperature profile and the pressure profile to perform the thermal bonding step are appropriately set typically within the condition ranges. The thermal bonding step as above can be performed using an apparatus that can perform heating and pressurization simultaneously. Non-limiting examples of such an apparatus include flip-chip bonders and parallel plate presses. The step is preferably performed in a nitrogen atmosphere, or under reduced pressure, or in a reducing gas atmosphere, to prevent or minimize oxidation of the metal or metals involved in sinter bonding.

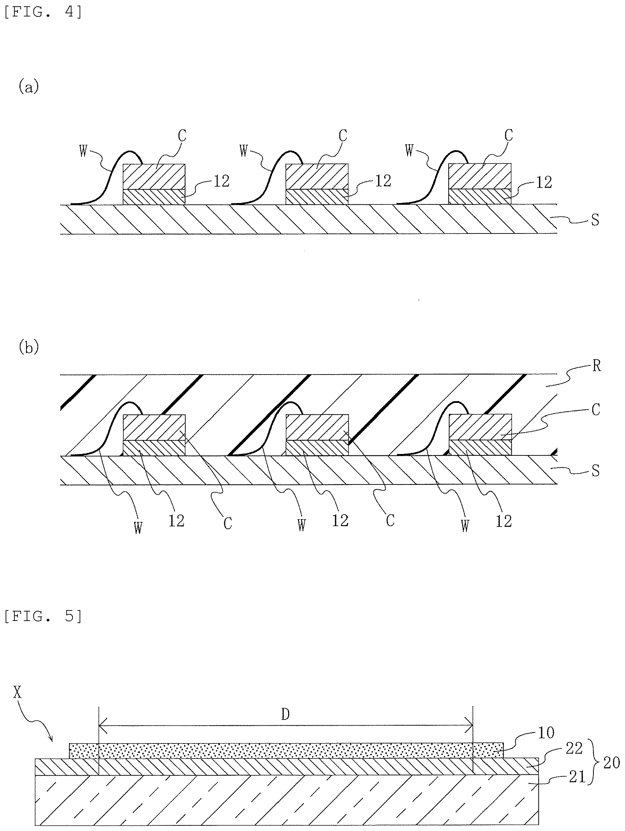

The semiconductor device production process then electrically couples the electrode pad (not shown) of each semiconductor chip C to a terminal area (not shown) of the supporting substrate S, through a bonding wire W according to necessity (wire bonding step), as illustrated in FIG. 4(a). The bonding wire W connects between the electrode pad of the semiconductor chip C and the terminal area of the supporting substrate S typically by ultrasonic welding with heating. The bonding wire W usable herein may be selected from gold wires, aluminum wires, and copper wires. The wire heating in the wire bonding is performed at a temperature of typically 80°C to 250°C, and preferably 80°C to 220°C, for a time of several seconds to several minutes.

Next, a resinous encapsulant R is disposed to protect the semiconductor chips C and the bonding wires W on the supporting substrate S (encapsulation step), as illustrated in FIG. 4(b). In this step, the resinous encapsulant R is disposed or formed by the transfer molding technology using dies. The resinous encapsulant R may be made typically from an epoxy resin. The heating to form the resinous encapsulant R in the step is performed at a temperature of typically 165°C to 185°C for a time of typically 60 seconds to several minutes. The resinous encapsulant R, when not sufficiently cured in the step (encapsulation step), subsequently undergoes a postcure step to be fully cured.

The procedure as above can produce a semiconductor device through the process using the thermal bonding sheet 10.

FIG. 5 is a schematic cross-sectional view of a thermal bonding sheet-associated dicing tape X according to an embodiment of the present invention. The thermal bonding sheet-associated dicing tape X has a multilayer structure including a dicing tape 20, and a thermal bonding sheet 10 according to an embodiment of the present invention. The thermal bonding sheet-associated dicing tape X is usable in semiconductor device production to give semiconductor chips each with a chip-size thermal bonding sheet. The thermal bonding sheet-associated dicing tape X typically has a disc-like shape having a size corresponding to a semiconductor wafer, which is a work in the semiconductor device production process.

The dicing tape 20 has a multilayer structure including a base 21 and a pressure-sensitive adhesive layer 22.

The base 21 of the dicing tape 20 is an element that functions as a support or backing in the dicing tape 20 or the thermal bonding sheet 10. The base 21 is advantageously selected typically from plastic bases (in particular, plastic films). Examples of materials to constitute the plastic bases include poly(vinyl chloride)s, poly(vinylidene chloride)s, polyolefins, polyesters, polyurethanes, polycarbonates, poly(ether ether ketone)s, polyimides, polyetherimides, polyamides, wholly aromatic polyamides, polyphenylsulfides, aramids, fluorocarbon resins, cellulosic resins, and silicone resins. Non-limiting examples of the polyolefins include low-density polyethylenes, linear polyethylenes, medium-density polyethylenes, high-density polyethylenes, ultralow-density polyethylenes, propylene random copolymers, propylene block copolymers, homopolypropylenes, polybutenes, polymethylpentenes, ethylene-vinyl acetate copolymers, ionomer resins, ethylene-(meth)acrylic acid copolymers, ethylene-(meth)acrylic ester copolymers, ethylene-butene copolymers, and ethylene-hexene copolymers. Non-limiting examples of the polyesters include poly(ethylene terephthalate)s (PETs), poly(ethylene naphthalate)s, and poly(butylene terephthalate)s (PBTs). The base 21 may be made from each of different materials alone or in combination. The base 21 may have a single-layer structure or a multilayer structure. When the pressure-sensitive adhesive layer 22 on the base 21 is curable with ultraviolet radiation as described later, the base 21 preferably has permeability to the ultraviolet radiation. The base 21, when being a plastic film, may be a non-oriented film, or an uniaxially oriented film, or a biaxially oriented film.

The base 21, at the surface facing the pressure-sensitive adhesive layer 22, may have undergone a treatment to have higher adhesion with the pressure-sensitive adhesive layer 22. Non-limiting examples of the treatment as above include physical treatments such as corona discharge treatment, plasma treatment, sand mat treatment, ozone exposure treatment, flame exposure treatment, high-voltage electric shock exposure treatment, and treatment with ionizing radiation; chemical treatments such as chromate treatment; and primer coating.

The base 21 has a thickness of preferably 40 µm or more, more preferably 50 µm or more, still more preferably 55 µm or more, and still more preferably 60 µm or more. This is preferred from the viewpoint of allowing the base 21 to surely have such a strength as to function as a support in the dicing tape 20 or in the thermal bonding sheet-associated dicing tape X. The thickness of the base 21 is preferably 200 µm or less, more preferably 180 µm or less, and still more preferably 150 µm or less, from the viewpoint of allowing the dicing tape 20 or the thermal bonding sheet-associated dicing tape X to actually have appropriate flexibility.

The pressure-sensitive adhesive layer 22 of the dicing tape 20 contains a pressure-sensitive adhesive. The pressure-sensitive adhesive usable herein may be selected from acrylic pressure-sensitive adhesives each including an acrylic polymer as a base polymer; and rubber pressure-sensitive adhesives. The pressure-sensitive adhesive may be an adhesive strength-reducible pressure-sensitive adhesive or an adhesive strength-non-reducible pressure-sensitive adhesive. The "adhesive strength-reducible pressure-sensitive adhesive" refers to a pressure-sensitive adhesive whose adhesive strength (tackiness) can be intentionally reduced by external action such as heating or radiation irradiation. The "adhesive strength-non-reducible pressure-sensitive adhesive" refers to a pressure-sensitive adhesive whose adhesive strength is little or not reduced by such external action. Non-limiting examples of the adhesive strength-reducible pressure-sensitive adhesive include radiation-curable pressure-sensitive adhesives (pressure-sensitive adhesives having curability with radiation) and thermally expandable pressure-sensitive adhesives. Non-limiting examples of the adhesive strength-non-reducible pressure-sensitive adhesive include so-called self-adhesive, pressure-sensitive adhesives.

Assume that the pressure-sensitive adhesive layer 22 contains an acrylic pressure-sensitive adhesive. In this case, an acrylic polymer, which serves as a base polymer of the acrylic pressure-sensitive adhesive, preferably includes a monomer unit derived from an alkyl acrylate and/or alkyl methacrylate in a largest mass proportion. Hereinafter, the term "(meth)acryl(ate)" indicates "acryl(ate)" and/or "methacryl(ate)".

Examples of the alkyl (meth)acrylate from which a monomer unit in the acrylic polymer is derived include alkyl (meth)acrylates each having a linear or branched chain alkyl moiety; and cycloalkyl (meth)acrylates. Non-limiting examples of the alkyl (meth)acrylate include, of (meth)acrylic acid, methyl, ethyl, propyl, isopropyl, butyl, isobutyl, s-butyl, t-butyl, pentyl, isopentyl, hexyl, heptyl, octyl, 2-ethylhexyl, isooctyl, nonyl, decyl, isodecyl, undecyl, dodecyl, tridecyl, tetradecyl, hexadecyl, octadecyl, and icosyl esters. Non-limiting examples of the cycloalkyl (meth)acrylates include, of (meth)acrylic acid, cyclopentyl and cyclohexyl esters. The acrylic polymer may include a monomer unit or units derived from each of different alkyl (meth)acrylates alone or in combination. The alkyl (meth)acrylate(s) is present in a proportion of typically 50 mass percent or more of the totality of monomer components to form the acrylic polymer, so as to allow the pressure-sensitive adhesive layer 22 to appropriately develop basic properties, such as tackiness, ascribed to the alkyl (meth)acrylate(s) .

The acrylic polymer may further include a monomer unit derived from another monomer that is copolymerizable with the alkyl (meth)acrylate(s), to modify any of its properties such as cohesive force and heat resistance. Examples of such a monomer component include carboxy-containing monomers, acid anhydride monomers, hydroxy-containing monomers, sulfonate-containing monomers, phosphate-containing monomers, acrylamide, and acrylonitrile. Non-limiting examples of the carboxy-containing monomers include acrylic acid, methacrylic acid, carboxyethyl (meth)acrylate, carboxypentyl (meth)acrylate, itaconic acid, maleic acid, fumaric acid, and crotonic acid. Non-limiting examples of the acid anhydride monomers include maleic anhydride and itaconic anhydride. Examples of the hydroxy-containing monomers include, but are not limited to, 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and 4-(hydroxymethyl)cyclohexylmethyl (meth)acrylate. Examples of the sulfonate-containing monomers include, but are not limited to, styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid. A non-limiting example of the phosphate-containing monomers is 2-hydroxyethylacryloyl phosphate. The acrylic polymer may be derived from monomers including each of different such other monomers alone or in combination. The monomer component(s) other than alkyl (meth)acrylates may be present in a proportion of typically 50 mass percent or less of the totality of monomer components to form the acrylic polymer. This is preferred for allowing the pressure-sensitive adhesive layer 22 to appropriately develop basic properties, such as tackiness, ascribed to the alkyl (meth)acrylate(s).

To form a cross-linked structure in its polymer skeleton, the acrylic polymer may include a monomer unit derived from a multifunctional monomer that is copolymerizable with the alkyl (meth)acrylate. Non-limiting examples of such a multifunctional monomer include hexanediol di(meth)acrylate, (poly)ethylene glycol di(meth)acrylate, (poly)propylene glycol di(meth)acrylate, neopentyl glycol di(meth)acrylate, pentaerythritol di(meth)acrylate, trimethylolpropane tri(meth)acrylate, pentaerythritol tri(meth)acrylate, dipentaerythritol hexa(meth)acrylate, epoxy (meth)acrylates, glycidyl (meth)acrylate, polyester (meth)acrylates, and urethane (meth)acrylates. The acrylic polymer may be derived from constitutional monomers including each of different multifunctional monomers alone or in combination. The multifunctional monomer(s) may be present in a proportion of typically 40 mass percent or less of the totality of monomer components to form the acrylic polymer, so as to allow the pressure-sensitive adhesive layer 22 to appropriately develop basic properties, such as tackiness, ascribed to the alkyl (meth)acrylate(s).

The acrylic polymer can be obtained by polymerizing a material monomer or monomers to form the polymer. Non-limiting examples of the polymerization technique include solution polymerization, emulsion polymerization, bulk polymerization, and suspension polymerization. The pressure-sensitive adhesive layer 22 in the dicing tape 20 or in the thermal bonding sheet-associated dicing tape X is preferably minimized in low-molecular-weight substances, from the viewpoint of providing high cleanliness in a semiconductor device production method using the dicing tape 20 or the thermal bonding sheet-associated dicing tape X. Thus, the acrylic polymer has a number-average molecular weight of typically 10 x10⁴ or more.

The pressure-sensitive adhesive layer 22, or the pressure-sensitive adhesive to constitute the layer 22, may contain an external crosslinker or another component to allow the acrylic polymer or another base polymer to have a higher number-average molecular weight. Non-limiting examples of the external crosslinker, which reacts with the acrylic polymer or another base polymer to form a cross-linked structure, include crosslinkers of polyisocyanate compounds, epoxy compounds, aziridine compounds, and melamine compounds. The external crosslinker may be present in the pressure-sensitive adhesive layer 22, or in the pressure-sensitive adhesive to constitute the layer 22, in an amount of typically 5 parts by mass or less per 100 parts by mass of the base polymer.

The pressure-sensitive adhesive layer 22 may be a radiation-curable pressure-sensitive adhesive layer whose adhesive strength decreases upon irradiation with radiation such as ultraviolet radiation, due to an increased degree of crosslinking in the irradiated portion. Non-limiting examples of the radiation-curable pressure-sensitive adhesive to constitute such a pressure-sensitive adhesive layer include compounded radiation-curable pressure-sensitive adhesives each containing a base polymer such as the acrylic pressure-sensitive adhesive or the rubber pressure-sensitive adhesive; and a radiation-polymerizable monomer component or oligomer component having a radiation-polymerizable carbon-carbon double bond or another radiation-polymerizable functional group.

Non-limiting examples of the radiation-polymerizable monomer component include urethane (meth)acrylates, trimethylolpropane tri(meth)acrylate, pentaerythritol tri(meth)acrylate, pentaerythritol tetra(meth)acrylate, dipentaerythritol monohydroxypenta(meth)acrylate, dipentaerythritol hexa(meth)acrylate, and 1,4-butanediol di(meth)acrylate. The radiation-polymerizable oligomer component is exemplified typically by a variety of oligomers such as urethane, polyether, polyester, polycarbonate, and polybutadiene oligomers, and may be selected appropriately from oligomers having a molecular weight of about 100 to about 30000. The pressure-sensitive adhesive layer 22, or the radiation-curable pressure-sensitive adhesive to constitute the layer 22, may contain the radiation-polymerizable monomer component and/or oligomer component in an amount of typically 40 to 150 parts by mass per 100 parts by mass of the base polymer such as the acrylic polymer, while the amount may be determined within such a range as to allow the resulting pressure-sensitive adhesive layer 22 to have an appropriately reduced adhesive strength. The compounded radiation-curable pressure-sensitive adhesive for use herein may be selected from those disclosed in JP-A No. S60-196956.

The radiation-curable pressure-sensitive adhesive to constitute the pressure-sensitive adhesive layer 22 may also be selected from endogenously-curable, radiation-curable pressure-sensitive adhesives each of which contains a base polymer containing a radiation-polymerizable carbon-carbon double bond or another radiation-polymerizable functional group in any of a polymer side chain, a polymer backbone, and a terminal of the polymer backbone. Such endogenously-curable, radiation-curable pressure-sensitive adhesives are advantageous for reducing unintended changes in adhesive properties with time, where the changes will be caused by migration of low molecular weight components in the resulting pressure-sensitive adhesive layer 22.

The endogenously-curable, radiation-curable pressure-sensitive adhesive preferably contains a base polymer that includes an acrylic polymer as a basic skeleton. The acrylic polymer to constitute such basic skeleton may be selected from the above-mentioned acrylic polymers. The radiation-polymerizable carbon-carbon double bond may be introduced into the acrylic polymer typically by a technique as follows. Specifically, material monomers including a monomer containing a predetermined functional group (first functional group) are copolymerized to give an acrylic polymer, and the acrylic polymer undergoes a condensation reaction or addition reaction with a compound containing a predetermined second functional group and a radiation-polymerizable carbon-carbon double bond, while maintaining the radiation-polymerizability of the carbon-carbon double bond, where the second functional group is a functional group capable of reacting with and bonding to the first functional group.

Non-limiting examples of the combination of the first functional group with the second functional group include the combinations of: carboxy with epoxy; epoxy with carboxy; carboxy with aziridyl; aziridyl with carboxy; hydroxy with isocyanato; and isocyanato with hydroxy. Among these combinations, the combination of hydroxy with isocyanato, and the combination of isocyanato with hydroxy are advantageous for easy tracking of the reaction. It is more advantageous that the first functional group contained in the acrylic polymer is hydroxy, and the second functional group is isocyanato, because, due to high reactivity of isocyanato, it is highly technically difficult to prepare an isocyanato-containing polymer. This configuration is preferred from the viewpoint of easiness in preparation, or availability, of the acrylic polymer. In this case, non-limiting examples of such a compound containing a radiation-polymerizable carbon-carbon double bond in combination with isocyanato as the second functional group, namely, non-limiting examples of an isocyanate compound containing a radiation-polymerizable unsaturated functional group include methacryloyl isocyanate, 2-methacryloyloxyethyl isocyanate, and m-isopropenyl-α,α-dimethylbenzyl isocyanate. The acrylic polymer containing the first functional group is advantageously selected from those including a monomer unit derived from the hydroxy-containing monomer and is also advantageously selected from those including a monomer unit derived from an ether compound such as 2-hydroxyethyl vinyl ether, 4-hydroxybutyl vinyl ether, or diethylene glycol monovinyl ether.

The radiation-curable pressure-sensitive adhesive to constitute the pressure-sensitive adhesive layer 22 preferably contains a photoinitiator. Examples of the photoinitiator include, but are not limited to, α-ketol compounds, acetophenone compounds, benzoin ether compounds, ketal compounds, aromatic sulfonyl chloride compounds, photoactive oxime compounds, benzophenone compounds, thioxanthone compounds, camphorquinone, halogenated ketones, acylphosphine oxides, and acylphosphonates. Non-limiting examples of the α-ketol compounds include 4-(2-hydroxyethoxy)phenyl (2-hydroxy-2-propyl) ketone, α-hydroxy-α,α'-dimethylacetophenone, 2-methyl-2-hydroxypropiophenone, and 1-hydroxycyclohexyl phenyl ketone. Non-limiting examples of the acetophenone compounds include methoxyacetophenone, 2,2-dimethoxy-2-phenylacetophenone, 2,2-diethoxyacetophenone, and 2-methyl-1-[4-(methylthio)-phenyl]-2-morpholinopropane-1. Non-limiting examples of the benzoin ether compounds include benzoin ethyl ether, benzoin isopropyl ether, and anisoin methyl ether. A non-limiting example of the ketal compounds is benzil dimethyl ketal. A non-limiting example of the aromatic sulfonyl chloride compounds is 2-naphthalenesulfonyl chloride. A non-limiting example of the photoactive oxime compounds is 1-phenon-1,2-propanedione-2-(O-ethoxycarbonyl) oxime. Non-limiting examples of the benzophenone compounds include benzophenone, benzoylbenzoic acid, and 3,3'-dimethyl-4-methoxybenzophenone. Non-limiting examples of the thioxanthone compounds include thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone. The radiation-curable pressure-sensitive adhesive to constitute the pressure-sensitive adhesive layer 22 may contain the photoinitiator in an amount of typically 0.05 to 20 parts by mass per 100 parts by mass of the base polymer such as the acrylic polymer.

In addition to the components, the pressure-sensitive adhesive layer 22, or the pressure-sensitive adhesive to constitute the layer 22, may further contain one or more additives exemplified typically by cross-linking promoters, tackifiers, age inhibitors, and colorants such as pigments and dyes. The colorants may be compounds that are colored by irradiation with radiation. Non-limiting examples of such compounds include leuco dyes.

The pressure-sensitive adhesive layer 22 has a thickness of 1 to 50 µm typically in the embodiment, from the viewpoint of the balance in bond strength of the pressure-sensitive adhesive layer 22 to the thermal bonding sheet 10 between before and after curing with radiation.

The thermal bonding sheet-associated dicing tape X, which has the configurations as above, can be prepared typically in the following manner.

The dicing tape 20 of the thermal bonding sheet-associated dicing tape X can be prepared by providing a pressure-sensitive adhesive layer 22 on a prepared base 21. For example, the base 21, when to be made from a resin, can be prepared by any of film-forming techniques such as filming by calender process, casting in an organic solvent, blow-extrusion in a closed system, T-die extrusion, coextrusion, and dry lamination. The pressure-sensitive adhesive layer 22 may be formed in the following manner. Initially, a pressure-sensitive adhesive composition for the formation of the pressure-sensitive adhesive layer 22 is prepared. The pressure-sensitive adhesive composition is applied onto the base 21 or onto a predetermined separator (namely, a release liner) to form a pressure-sensitive adhesive composition layer. The pressure-sensitive adhesive composition layer undergoes, as needed, desolvation or another treatment (in this treatment, the composition undergoes thermal crosslinking as needed). The pressure-sensitive adhesive composition may be applied by a coating technique such as roll coating, screen coating, or gravure coating. The desolvation or another treatment of the pressure-sensitive adhesive composition layer may be performed at a temperature of typically 80°C to 150°C for a time of typically 0.5 to 5 minutes. The pressure-sensitive adhesive layer 22, when formed on a separator, the pressure-sensitive adhesive layer 22 with the separator is applied to the base 21. The procedure can give the dicing tape 20.

The thermal bonding sheet 10 of the thermal bonding sheet-associated dicing tape X can be prepared in the following manner. Initially, a composition to form the thermal bonding sheet 10 is prepared, the composition is applied onto a predetermined separator to form a composition layer, and the composition layer is dried to give the sheet 10. The composition may be applied by a coating technique such as roll coating, screen coating, or gravure coating. The drying of the composition layer is performed at a temperature of typically 70°C to 160°C for a time of typically 1 to 5 minutes.

In the preparation of the thermal bonding sheet-associated dicing tape X, next, the thermal bonding sheet 10 is laminated onto the pressure-sensitive adhesive layer 22 side of the dicing tape 20 typically by compression bonding. The lamination is performed at a temperature of typically 30°C to 50°C and a pressure (linear load) of typically 0.1 to 20 kgf/cm. The pressure-sensitive adhesive layer 22, when being a radiation-curable pressure-sensitive adhesive layer as described above, may subsequently undergo irradiation with radiation such as ultraviolet radiation, typically from the surface of the base 21. The irradiation is performed at an irradiance of typically 50 to 500 mJ, and preferably 100 to 300 mJ. The thermal bonding sheet-associated dicing tape X has a region (irradiation region D) which is to be irradiated with radiation to reduce the adhesive strength of the pressure-sensitive adhesive layer 22. The region D is, for example, a region on which the thermal bonding sheet is laminated, excluding the periphery thereof, in the pressure-sensitive adhesive layer 22.

The above procedure can give, for example, the thermal bonding sheet-associated dicing tape X as illustrated in FIG. 5. The thermal bonding sheet-associated dicing tape X may bear a separator (not shown) to cover the pressure-sensitive adhesive layer 22 associated with the thermal bonding sheet 10. The separator is an element to protect the pressure-sensitive adhesive layer 22 and the thermal bonding sheet 10 from being exposed, and is removed from the tape before use of the thermal bonding sheet-associated dicing tape X. Examples of the separator for use herein include poly(ethylene terephthalate) (PET) films; polyethylene films; polypropylene films; and various plastic films or paper whose surface is coated with a release agent (such as a fluorine release agent or a long-chain alkyl acrylate release agent).

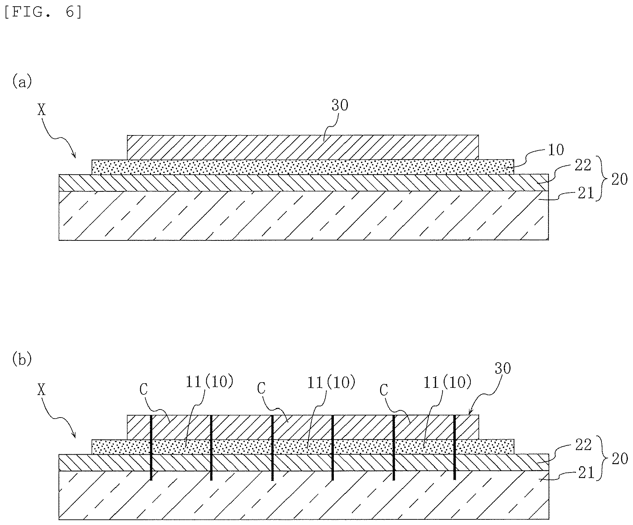

FIG. 6 illustrates a part of steps in a semiconductor device production method using the thermal bonding sheet-associated dicing tape X.

The method initially applies a semiconductor wafer 30 onto the thermal bonding sheet 10 of the thermal bonding sheet-associated dicing tape X, as illustrated in FIG. 6(a). Specifically, the semiconductor wafer 30 sticks to the thermal bonding sheet-associated dicing tape X or the thermal bonding sheet 10 of the dicing tape X while being pressed toward the thermal bonding sheet 10 typically using a pressure roller. The semiconductor wafer 30 includes already-fabricated semiconductor elements and bears a silver plane electrode (not shown) already made as an external electrode at the surface to be applied to the thermal bonding sheet 10 (the upper side in FIG. 6). The silver plane electrode has a thickness of typically 10 to 1000 nm. The silver plane electrode may be laminated on a thin titanium film formed on the surface of the semiconductor wafer. The thin titanium film has a thickness of typically 10 to 1000 nm. These silver plane electrode and thin titanium film can be formed typically by a vapor deposition technique. The semiconductor wafer 30, on the other side (under side in FIG. 6), bears other components such as electrode pads (not shown) as needed for each semiconductor element. The step performs the lamination at a temperature of typically 50°C to 90°C under a load of typically 0.01 to 10 MPa. Assume that the pressure-sensitive adhesive layer 22 in the thermal bonding sheet-associated dicing tape X is a radiation-curable pressure-sensitive adhesive layer. In this case, instead of the radiation irradiation in the production process of the thermal bonding sheet-associated dicing tape X, irradiation of the pressure-sensitive adhesive layer 22 with radiation such as ultraviolet radiation through the base 21 may be performed after the lamination of the semiconductor wafer 30 to the thermal bonding sheet-associated dicing tape X. This irradiation is performed at an irradiance of typically 50 to 500 mJ, and preferably 100 to 300 mJ. The thermal bonding sheet-associated dicing tape X has a region (irradiation region D indicated in FIG. 5) which is to be irradiated with radiation to reduce the adhesive strength of the pressure-sensitive adhesive layer 22. This region is, for example, a region on which the thermal bonding sheet is laminated, excluding the periphery thereof, in the pressure-sensitive adhesive layer 22.

The semiconductor wafer 30 then undergoes dicing, as illustrated in FIG. 6(b). Specifically, the semiconductor wafer 30, while being held by the thermal bonding sheet-associated dicing tape X, undergoes dicing using a rotary blade typically of a dicer, to be singularized into semiconductor chips (cutting portions are schematically indicated by thick lines in the figure). This gives semiconductor chips C each with a chip-size piece of the thermal bonding sheet 10.

Where necessary, the work then undergoes a cleaning step in which the surfaces of the semiconductor chips C on the thermal bonding sheet over the dicing tape 20 are cleaned with a cleaning liquid such as water. Each thermal bonding sheet-associated semiconductor chip C is then picked up from the dicing tape 20 (picking-up step). For example, a thermal bonding sheet-associated semiconductor chip C to be picked up is plunged up through the dicing tape 20 by elevating a pin lifter of a picking-up mechanism (not shown) from below the dicing tape 20 in the figure, and sucked and held by a suction tool (not shown).

Next, each semiconductor chip C is temporarily secured to a supporting substrate S (temporary securing step), as illustrated in FIG. 3(a); and undergoes a high-temperature heating process to bond to the supporting substrate S (thermal bonding step), as illustrated in FIG. 3(b). Specific embodiments and conditions for these steps are as described above relating to the temporary securing step and the thermal bonding step in the semiconductor device production method using the thermal bonding sheet 10, with reference to FIG. 3(a) and FIG. 3(b).

Next, the electrode pad (not shown) of each semiconductor chip C and the terminal area (not shown) of the supporting substrate S are electrically connected to each other, as needed through a bonding wire W (wire bonding step), as illustrated in FIG. 4(a). Next, a resinous encapsulant R is disposed or formed to protect the semiconductor chips C and the bonding wires W on the supporting substrate S (encapsulation step), as illustrated in FIG. 4(b). Specific embodiments and conditions for these steps are as described above relating to the temporary securing step and the thermal bonding step in the semiconductor device production method using the thermal bonding sheet 10, with reference to FIG. 4(a) and FIG. 4(b).

The above procedure can give a semiconductor device through the process using the thermal bonding sheet-associated dicing tape X.

In the thermal bonding sheet 10, the pressure-sensitive adhesive layer 11 has a first shear bond strength of 0.1 MPa or more, preferably 0.12 MPa or more, more preferably 0.14 MPa or more, still more preferably 0.16 MPa or more, still more preferably 0.18 MPa or more, and still more preferably 0.2 MPa or more, where the first shear bond strength is a shear bond strength determined at 70°C with respect to a silver plane to which the pressure-sensitive adhesive layer 11 as a 5-mm square piece has been compression-bonded under the first compression bonding conditions (70°C, 0.5 MPa, 1 second). Assuming that a semiconductor chip C sinters and bonds to a supporting substrate S using the thermal bonding sheet 10 as described above. In this case, the configuration as above is advantageous for reducing chip shift, namely, misalignment of the semiconductor chip C during temporary securing of the semiconductor chip C to the supporting substrate S by compression bonding, with the thermal bonding sheet 10 being disposed between the supporting substrate S and the semiconductor chip C. Such reduction in misalignment during temporary securing is advantageous for preventing or minimizing sinter bonding of the semiconductor chip C to the supporting substrate S with misalignment beyond the bounds of permissibility and is advantageous for better yield of the semiconductor device to be produced.

The thermal bonding sheet 10 is a thermal-bonding material for sinter bonding that is fed not in the form of a paste, but in the form of a sheet, which is readily preparable to have an even thickness. Thus, the thermal bonding sheet 10 enables bonding between the supporting substrate S and the semiconductor chip C through the sintered layer 12 having an even thickness. The sinter bonding through the sintered layer 12 having an even thickness is advantageous for actually providing high bonding reliability of the semiconductor chip C to the supporting substrate S.

In addition, the thermal bonding sheet 10 is a thermal-bonding material for sinter bonding that is fed not in the form of a paste, which tends to undergo fluidization, but in the form of a sheet, which resists fluidization. The thermal bonding sheet 10 is suitable for sinter bonding of the semiconductor chip C to the supporting substrate S while impeding the sintered metal from oozing from between the bonding targets, i.e., the supporting substrate S and the semiconductor chip C and from creeping up to the semiconductor chip C. The reduction in oozing and creeping up as above is advantageous for better yield in such semiconductor device production with sinter bonding.

In the thermal bonding sheet 10, the pressure-sensitive adhesive layer 11 has a ratio of the second shear bond strength to the first shear bond strength of preferably 5 to 40, as described above, where the first shear bond strength is a shear bond strength determined at 70°C with respect to a silver plane to which the pressure-sensitive adhesive layer 11 as a 5-mm square piece has been compression-bonded under the first compression bonding conditions (70°C, 0.5 MPa, 1 second), and where the second shear bond strength is a shear bond strength determined at 23°C with respect to a silver plane to which the pressure-sensitive adhesive layer 11 as a 5-mm square piece has been compression-bonded under the first compression bonding conditions (70°C, 0.5 MPa, 1 second). When having this configuration, the thermal bonding sheet 10 surely have a such a relative strength of the first shear bond strength to the second shear bond strength that the ratio of the second shear bond strength to the first shear bond strength falls in the range of 5 to 40, where the second shear bond strength is determined at a temperature of 23°C in the normal temperature range, and the first shear bond strength is determined at a temperature of 70°C in the temporary securing temperature range. This configuration is preferred for reducing the chip shift or misalignment.

The pressure-sensitive adhesive layer 11 in the thermal bonding sheet 10 has a third shear bond strength of preferably 0.11 MPa or more, as described above, where the third shear bond strength is a shear bond strength determined at 50°C with respect to a silver plane to which the pressure-sensitive adhesive layer 11 as a 5-mm square piece has been compression-bonded under the second compression bonding conditions (50°C, 0.5 MPa, 1 second). The temporary securing step is performed at a temperature of typically 50°C to 90°C, as described above. The configuration in which the pressure-sensitive adhesive layer has a third shear bond strength of 0.11 MPa or more under the temperature condition is preferred for reducing the chip shift or misalignment.

The pressure-sensitive adhesive layer 11 in the thermal bonding sheet 10 has a ratio of the third shear bond strength to the first shear bond strength of preferably 1 to 40, as described above, where the first shear bond strength is a shear bond strength determined at 70°C with respect to a silver plane to which the pressure-sensitive adhesive layer 11 as a 5-mm square piece has been compression-bonded under the first compression bonding conditions (70°C, 0.5 MPa, 1 second), and where the third shear bond strength is a shear bond strength determined at 50°C with respect to a silver plane to which the pressure-sensitive adhesive layer 11 as a 5-mm square piece has been compression-bonded under the second compression bonding conditions (50°C, 0.5 MPa, 1 second). The configuration as above is preferred for allowing the thermal bonding sheet 10 to offer a stable bond strength within the temporary securing temperature range and is preferred for reducing the chip shift or misalignment.

The pressure-sensitive adhesive layer 11 in the thermal bonding sheet 10 has a ratio of the fourth shear bond strength to the first shear bond strength of preferably 1 to 40, as described above, where the first shear bond strength is a shear bond strength determined at 70°C with respect to a silver plane to which the pressure-sensitive adhesive layer 11 as a 5-mm square piece has been compression-bonded under the first compression bonding conditions (70°C, 0.5 MPa, 1 second), and the fourth shear bond strength is a shear bond strength determined at 90°C with respect to a silver plane to which the pressure-sensitive adhesive layer 11 as a 5-mm square piece has been compression-bonded under the third compression bonding conditions (90°C, 0.5 MPa, 1 second). The configuration as above is preferred for allowing the thermal bonding sheet 10 to actually have a stable adhesive strength within the temporary securing temperature range and is preferred for reducing the chip shift or misalignment.

The thermal bonding sheet 10 or the pressure-sensitive adhesive layer 11 has a viscosity at 70°C of preferably 5 ×10³ to 1 ×10⁷ Pa·s, as described above. The configuration as above is preferred for actually providing a first shear bond strength at the specific level or greater.

The thermal bonding sheet 10 or the pressure-sensitive adhesive layer 11 preferably further includes a thermally decomposable polymer binder in combination with the sinterable particles containing a conductive metal, and the thermally decomposable polymer binder has a weight-average molecular weight of preferably 10000 or more, as described above. These configurations allow the pressure-sensitive adhesive layer 11 to readily surely have cohesive force typically using the viscoelasticity of the thermally decomposable polymer binder and to thereby readily surely have a bond strength at a certain level, in the temperature range of 50°C to 90°C, which is a temperature range including the temporary securing temperature in the temporary securing step, namely, 70°C and the vicinities thereof. Thus, these configurations are advantageous for actually providing a first shear bond strength at the specific level or greater.

The thermally decomposable polymer binder contained in the thermal bonding sheet 10 or in the pressure-sensitive adhesive layer 11 is preferably at least one of a polycarbonate resin and an acrylic resin, as described above. Such a polycarbonate resin and an acrylic resin is readily available as a polymer binder that decomposes and/or vaporizes at a temperature around 300°C. The configuration is advantageous for allowing the sintered layer 12 to be reduced in organic residues, where the sintered layer 12 is formed between the supporting substrate S and the semiconductor chip C which sinter and bond to each other using the thermal bonding sheet 10. With a decreasing content of organic residues, the sintered layer 12 tends to be stronger and more readily offers excellent bonding reliability.

### Examples

### Example 1

A varnish was prepared by mixing 225 parts by mass of fine silver particles (having an average particle size of 100 nm, DOWA Electronics Materials Co., Ltd.) as sinterable particles; 25 parts by mass of a polycarbonate resin QPAC40 (trade name, having a weight-average molecular weight of 150000, solid at normal temperature, Empower Materials) as a thermally decomposable polymer binder; 16 parts by mass of isobornylcyclohexanol TERSOLVE MTPH (trade name, liquid at normal temperature, Nippon Terpene Chemicals, Inc.) as a low-boiling binder; and 10 parts by mass of methyl ethyl ketone as a solvent. The mixing was performed using a hybrid mixer HM-500 (trade name, KEYENCE CORPORATION) in its stirring mode for a time of 3 minutes. The resulting varnish was applied to a release-treated film MRA 50 (trade name, Mitsubishi Plastics, Inc.) and dried to form a 40-µm thick pressure-sensitive adhesive layer. The drying was performed at a temperature of 110°C for a time of 3 minutes. This procedure gave a thermal bonding sheet according to Example 1, where the sheet included a pressure-sensitive adhesive layer including the sinterable particles, the thermally decomposable polymer binder, and the low-boiling binder. Table 1 presents the formula of the thermal bonding sheet according to Example 1. For other examples and comparative examples described later, Table 1 also presents their formulae. In Table 1, numerical values indicating formulae are indicated in relative "part by mass".

### Example 2

A thermal bonding sheet according to Example 2 was prepared by a procedure similar to that for the thermal-bonding material of Example 1, except for using, as a thermally decomposable polymer binder instead of the polycarbonate resin, 25 parts by mass of an acrylic resin MM2002-1 (trade name, having a weight-average molecular weight of 170000, solid at normal temperature, Fujikura Kasei Co., Ltd.).

### Example 3

A thermal bonding sheet according to Example 3 was prepared by a procedure similar to that for the thermal-bonding material of Example 1, except for using, as sinterable particles instead of the fine silver particles, 335 parts by mass of fine copper particles (having an average particle size of 200 µm, MITSUI MINING & SMELTING CO., LTD.); and using, as a thermally decomposable polymer binder instead of the polycarbonate resin, 38 parts by mass of an acrylic resin MM2002-1 (trade name, having a weight-average molecular weight of 170000, solid at normal temperature, Fujikura Kasei Co., Ltd.).

### Comparative Example 1

A thermal bonding sheet according to Comparative Example 1 was prepared by a procedure similar to that for the thermal-bonding material of Example 1, except for using, as a binder solid at normal temperature instead of the polycarbonate resin, 25 parts by mass of 1-octadecanol, which has a low molecular weight (molecular weight: 270.49, solid at normal temperature).

### Bond Strength Measurement at 70°C

Each of the thermal bonding sheets according to Examples 1 to 3 and Comparative Example 1 was evaluated for bond strength at 70°C. Specifically, a silicon chip (5-mm square) having a silver plane electrode (5-mm square) formed on one side of the chip as a vapor-deposited film was prepared; and a sample thermal bonding sheet was laminated onto the silver plane electrode using a laminator equipped with a pressure roller. The lamination was performed at a temperature of 70°C and a speed of the pressure roller of 10 mm/second under a load (pressure applied by the pressure roller) of 0.5 MPa. The procedure as above gave a silicon chip with a 5-mm square thermal bonding sheet or pressure-sensitive adhesive layer on one side. The resulting thermal bonding sheet-associated silicon chip was compression-bonded to and temporarily secured to a silver-plated copper sheet (20-mm square) using a die bonding machine, Die Bonder SPA-300 (trade name, SHINKAWA LTD.). The copper sheet had undergone silver plating to have a silver plane on its surface. In the step, the silicon chip was temporarily secured through the thermal bonding sheet to the silver plane. The compression bonding in the temporary securing was performed at a temperature of 70°C and a pressure of 0.5 MPa for a time of 1 second. The thermal bonding sheet compression-bonded to the silver-plated copper sheet was evaluated for shear bond strength (first shear bond strength) by measurement using a bond tester (shear bond strength measuring apparatus) DAGE 4000 (trade name, Nordson DAGE). The measurement was performed at a temperature of 70°C and a speed of the tool that pressed and moved the thermal bonding sheet-associated silicon chip to the shear direction of 0.5 mm/second. Table 1 presents the measured first shear bond strength (MPa) of each thermal bonding sheet.

### Bond Strength Measurement at 23°C

Each of the thermal bonding sheets according to Examples 1 to 3 and Comparative Example 1 was evaluated for bond strength at 23°C. Specifically, a silicon chip (5-mm square) having a silver plane electrode (5-mm square) formed on one side of the chip as a vapor-deposited film was prepared; and a sample thermal bonding sheet was laminated onto the silver plane electrode using a laminator equipped with a pressure roller. The lamination was performed at a temperature of 70°C and a speed of the pressure roller of 10 mm/second under a load (pressure applied by the pressure roller) of 0.5 MPa. The procedure as above gave a silicon chip with a 5-mm square thermal bonding sheet or pressure-sensitive adhesive layer on one side. The resulting thermal bonding sheet-associated silicon chip was compression-bonded to and temporarily secured to a silver-plated copper sheet (20-mm square) using a die bonding machine, Die Bonder SPA-300 (trade name, SHINKAWA LTD.). The copper sheet had undergone silver plating to have a silver plane on its surface. In the step, the silicon chip was temporarily secured through the thermal bonding sheet to the silver plane. The compression bonding in the temporary securing was performed at a temperature of 70°C and a pressure (load) of 0.5 MPa, for a time of 1 second. The thermal bonding sheet compression-bonded to the silver-plated copper sheet was evaluated for shear bond strength (second shear bond strength) by measurement using the Bond Tester DAGE 4000 (trade name, Nordson DAGE). The measurement was performed at a temperature of 23°C and a speed of the tool that pressed and moved the thermal bonding sheet-associated silicon chip to the shear direction of 0.5 mm/second. Table 1 presents the measured second shear bond strength (MPa) of each thermal bonding sheet.

### Chip Shift Resistance (200°C)

Each of the thermal bonding sheets according to Examples 1 to 3 and Comparative Example 1 was evaluated for the presence or absence of chip shift when undergoing predetermined high-temperature heating. Specifically, a silicon chip (5-mm square) having a silver plane electrode (5-mm square) formed on one side of the chip as a vapor-deposited film was prepared; and a sample thermal bonding sheet was laminated onto the silver plane electrode using a laminator equipped with a pressure roller. The lamination was performed at a temperature of 70°C and a speed of the pressure roller of 10 mm/second under a load (pressure applied by the pressure roller) of 0.5 MPa. The procedure as above gave a silicon chip with a 5-mm square thermal bonding sheet or pressure-sensitive adhesive layer on one side. The resulting thermal bonding sheet-associated silicon chip was compression-bonded to and temporarily secured to a silver-plated copper sheet (20-mm square) using a die bonding machine, Die Bonder SPA-300 (trade name, SHINKAWA LTD.). The copper sheet had undergone silver plating to have a silver plane on its surface. In the step, the silicon chip was temporarily secured through the thermal bonding sheet to the silver plane. The compression bonding in the temporary securing was performed at a temperature of 70°C and a pressure (under a load) of 0.5 MPa, for a time of 1 second. The procedure as above gave five specimens per each of the thermal bonding sheets according to Examples 1 to 3 and Comparative Example 1. The prepared specimens were heated in an oven LC-114 (trade name, ESPEC Corporation) (heat treatment). The heating in the treatment was performed at a temperature of 200°C for a time of 1 hour. After the heat treatment as above, the number of specimens that suffered from misalignment (chip shift) of 10 µm or more from the position at which the sample was temporarily secured to the silicon chip was counted. In Examples 1 to 3, zero of the five specimens suffered from such chip shift, whereas in Comparative Example 1, two of the five specimens suffered from the chip shift. A sample having a number of specimens suffering from chip shift of zero was evaluated as having good chip shift resistance (Good), whereas a sample having a number of specimens suffering from chip shift of 1 or more was evaluated as having poor chip shift resistance (Poor). Table 1 presents these results.

### Chip Shift Resistance (300°C)

Each of the thermal bonding sheets according to Examples 1 to 3 and Comparative Example 1 was evaluated for the presence or absence of chip shift during sinter bonding. Specifically, a silicon chip (5-mm square) having a silver plane electrode (5-mm square) formed on one side of the chip as a vapor-deposited film was prepared; and a sample thermal bonding sheet was laminated onto the silver plane electrode using a laminator equipped with a pressure roller. The lamination was performed at a temperature of 70°C and a speed of the pressure roller of 10 mm/second under a load (pressure applied by the pressure roller) of 0.5 MPa. The procedure as above gave a silicon chip with a 5-mm square thermal bonding sheet or pressure-sensitive adhesive layer on one side. The resulting thermal bonding sheet-associated silicon chip was compression-bonded to and temporarily secured to a silver-plated copper sheet (20-mm square) using a die bonding machine, Die Bonder SPA-300 (trade name, SHINKAWA LTD.). The copper sheet had undergone silver plating to have a silver plane on its surface. In the step, the silicon chip was temporarily secured through the thermal bonding sheet to the silver plane. The compression bonding in the temporary securing was performed at a temperature of 70°C and a pressure (under a load) of 0.5 MPa, for a time of 1 second. The procedure as above gave five specimens per each of the thermal bonding sheets according to Examples 1 to 3 and Comparative Example 1. The prepared specimens underwent a sintering step using a sintering apparatus HTM-3000 (trade name, Hakuto Co., Ltd.). The sintering was performed by heating at a temperature of 300°C and a pressure (a load) of 40 MPa for a time of 5 minutes. After the sintering step as above, the number of specimens that suffered from misalignment (chip shift) of 10 µm or more from the temporarily secured position in the silicon chip was measured. In Examples 1 to 3, zero of the five specimens suffered from the chip shift, whereas in Comparative Example 1, one of the five specimens suffered from the chip shift. A sample having a number of specimens suffering from chip shift of zero was evaluated as having good chip shift resistance (Good), whereas a sample having a number of specimens suffering from chip shift of 1 or more was evaluated as having poor chip shift resistance (Poor). Table 1 presents these results.

### Evaluation

The thermal bonding sheets according to Examples 1 to 3 could actually provide sinter bonding between bonding targets while reducing or minimizing misalignment of the bonding targets. The thermal bonding sheet according to Comparative Example 1 suffered from misalignment of bonding targets upon sinter bonding between the bonding targets.

**[Table 1]**

| | | | Example 1 | Example 2 | Example 3 | Comparative Example 1 |
|---|---|---|---|---|---|---|
| Sinterable particles | Fine silver particles | | 225 | 225 | - | 225 |
| | Fine copper particles | | - | - | 335 | - |
| Binder solid at normal temperature | Thermally decomposable polymer | Polycarbonate resin | 25 | - | - | - |
| | | Acrylic resin | - | 25 | 38 | - |
| | Low-molecular-weight compound | 1-Octadecanol | - | - | - | 25 |
| Binder liquid at normal temperature | Isobornylcyclohexanol | | 16 | 16 | 25 | 16 |
| First shear bond strength at 70°C (MPa) | | | 0.16 | 0.12 | 0.22 | 0.01 |
| Second shear bond strength at 23°C (MPa) | | | 1.62 | 4.87 | 1.35 | 1.67 |
| Ratio of second shear bond strength to first shear bond strength | | | 10.0 | 39.7 | 6.2 | 132.8 |
| Chip shift resistance (200°C) | | | Good | Good | Good | Poor |
| | | | (0/5) | (0/5) | (0/5) | (2/5) |
| Chip shift resistance (300°C) | | | Good | Good | Good | Poor |
| | | | (0/5) | (0/5) | (0/5) | (1/5) |

### Reference Signs List

- 10: thermal bonding sheet
- 11: pressure-sensitive adhesive layer
- 12: sintered layer
- C: semiconductor chip
- X: thermal bonding sheet-associated dicing tape
- 20: dicing tape
- 21: base
- 22: pressure-sensitive adhesive layer
- 30: semiconductor wafer

## Claims

1. A thermal bonding sheet comprising
a pressure-sensitive adhesive layer including sinterable particles containing a conductive metal,
the pressure-sensitive adhesive layer having a first shear bond strength of 0.1 MPa or more, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second.

2. The thermal bonding sheet according to claim 1,
wherein the pressure-sensitive adhesive layer has a second shear bond strength and has a ratio of the second shear bond strength to the first shear bond strength of 5 to 40, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second, and where the second shear bond strength is a shear bond strength determined at 23°C with respect to a silver plane to which the pressure-sensitive adhesive layer as a 5-mm square piece has been compression-bonded under compression bonding conditions of 70°C, 0.5 MPa, and 1 second.

3. The thermal bonding sheet according to one of claims 1 and 2,
wherein the pressure-sensitive adhesive layer has a third shear bond strength of 0.11 MPa or more, where the third shear bond strength is a shear bond strength determined at 50°C with respect to a silver plane to which the pressure-sensitive adhesive layer as a 5-mm square piece has been compression-bonded under compression bonding conditions of 50°C, 0.5 MPa, and 1 second.

4. The thermal bonding sheet according to any one of claims 1 to 3,
wherein the pressure-sensitive adhesive layer has a third shear bond strength and has a ratio of the third shear bond strength to the first shear bond strength of 1 to 40, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second, and where the third shear bond strength is a shear bond strength determined at 50°C with respect to a silver plane to which the pressure-sensitive adhesive layer as a 5-mm square piece has been compression-bonded under compression bonding conditions of 50°C, 0.5 MPa, and 1 second.

5. The thermal bonding sheet according to any one of claims 1 to 4,
wherein the pressure-sensitive adhesive layer has a fourth shear bond strength and has a ratio of the fourth shear bond strength to the first shear bond strength of 1 to 40, where the first shear bond strength is a shear bond strength determined at 70°C with respect to a silver plane to which the pressure-sensitive adhesive layer as a 5-mm square piece has been compression-bonded under compression bonding conditions of 70°C, 0.5 MPa, and 1 second, and where the fourth shear bond strength is a shear bond strength determined at 90°C with respect to a silver plane to which the pressure-sensitive adhesive layer as a 5-mm square piece has been compression-bonded under compression bonding conditions of 90°C, 0.5 MPa, and 1 second.

6. The thermal bonding sheet according to any one of claims 1 to 5,
wherein the pressure-sensitive adhesive layer has a viscosity of 5 × 10³ to 1 × 10⁷ Pa·s at 70°C.

7. The thermal bonding sheet according to any one of claims 1 to 6,
wherein the pressure-sensitive adhesive layer comprises a thermally decomposable polymer binder.

8. The thermal bonding sheet according to claim 7,
wherein the thermally decomposable polymer binder has a weight-average molecular weight of 10000 or more.

9. The thermal bonding sheet according to one of claims 7 and 8,
wherein the thermally decomposable polymer binder is at least one of a polycarbonate resin and an acrylic resin.

10. The thermal bonding sheet according to any one of claims 1 to 9,
wherein the sinterable particles comprise at least one selected from the group consisting of silver, copper, silver oxide, and copper oxide.

11. A thermal bonding sheet-associated dicing tape comprising:
a dicing tape having a multilayer structure including:
a base; and
a pressure-sensitive adhesive layer; and
the thermal bonding sheet according to any one of claims 1 to 10 disposed on the pressure-sensitive adhesive layer of the dicing tape.
